# EUROPEAN PATENT SPECIFICATION

(11) **EP 1 641 015 B1**
(45) Date of publication and mention of the grant of the patent: **12.11.2008**
(21) Application number: 05108582.7
(22) Date of filing: 19.09.2005
(51) Int. Cl.: H01J 17/28, H01J 17/49

(54) **Plasma display apparatus**
Plasmaanzeigetafel
Panneau d'affichage à plasma

(30) Priority: 24.09.2004 KR 2004077064; 27.04.2005 KR 2005034944
(43) Date of publication of application: 29.03.2006
(73) Proprietor: Samsung SDI Co., Ltd., Suwon-si Gyeonggi-do (KR)
(72) Inventor: Kim, Ki-Jung, Legal & IP Team, Kiheung-Eup, Yongin-City, Kyeonggi-Do (KR); Kim, Hyouk, Legal & IP Team, Kiheung-Eup, Yongin-City, Kyeonggi-Do (KR); Cho, In-Soo, Legal & IP Team, Kiheung-Eup, Yongin-City, Kyeonggi-Do (KR)
(74) Representative: Hengelhaupt, Jürgen

(56) References cited:
- US-A1- 2002 012 762
- US-A1- 2002 153 840
- US-A1- 2004 174 114
- PATENT ABSTRACTS OF JAPAN vol. 008, no. 103 (E-244), 15 May 1984 (1984-05-15) & JP 59 020947 A (FUJITSU KK), 2 February 1984 (1984-02-02)

## Description

### BACKGROUND OF THE INVENTION

### Field of the Invention

The present invention relates to a plasma display apparatus and, in particular, to the effective arrangement and attachment of heat spread sheets and double-sided tapes between a plasma display panel and a chassis base thereof.

### Description of the Related Technology

It is well known that a plasma display apparatus uses plasma generated by gas discharge to produce an image on a plasma display panel (PDP). The plasma display apparatus comprises a PDP; a chassis base of which a first side supports the PDP; driving circuit boards, attached on a second side, the second side opposite the first side of the chassis base where the PDP is supported, the driving circuit boards being electrically connected to sustain electrodes and address electrodes of the PDP via a flexible printed circuit and connectors; and a case housing the PDP, the chassis base, and the driving circuit boards, and forming an external case of the plasma display apparatus.

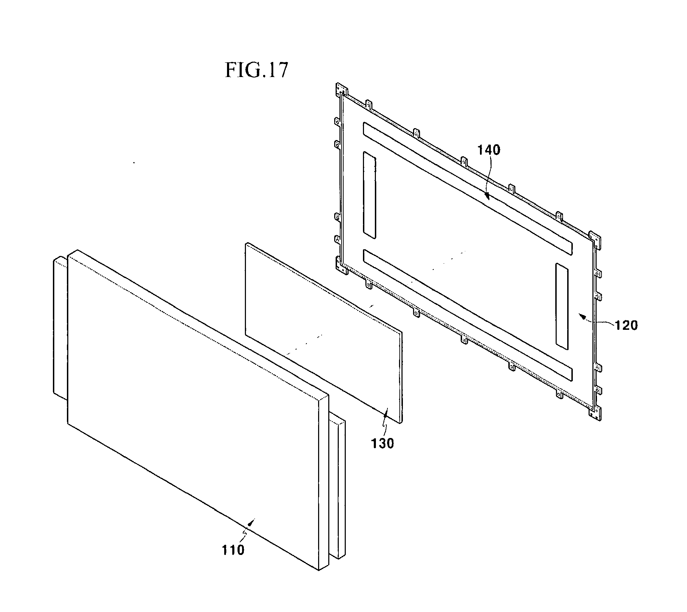

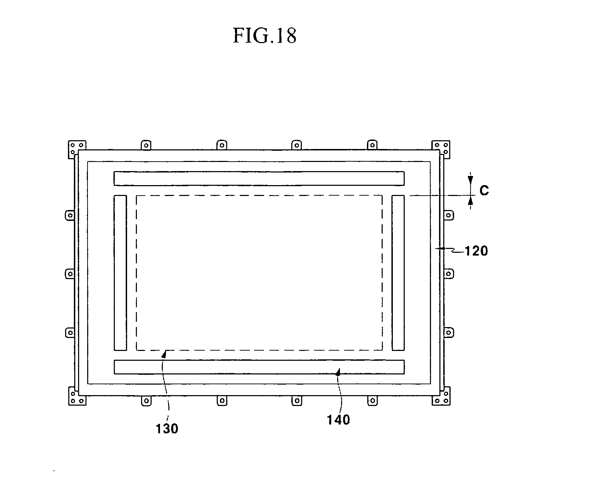

Fig. 17 is a perspective view of a prior plasma display apparatus showing assembling a unit module. Fig. 18 is a plan view of a chassis base of a prior plasma display apparatus.

According to Figures 17 and 18, a PDP 110 placed inside the case is attached to a chassis base 120 via double-sided tapes 140. The chassis base 120 is made of a metallic material with a high mechanical strength to support the PDP 110. A heat spread sheet 130 is placed between the PDP 110 and the chassis base 120 for transferring heat from the PDP 110 to the chassis base 120.

The PDP 110 is made of two hermetically sealed glass substrates facing each other and having discharge cells therebetween. The PDP 110 is shock-sensitive and fragile in terms of mechanical strength. The PDP 110 produces a large amount of heat during its operation and has a heat spread sheet 130 on the backside thereof. The heat spread sheet 130 spreads the heat from the PDP 110 in the plane-wise direction effectively.

In addition to the role of maintaining the mechanical strength of the PDP 110, the chassis base 120 serves as a mount for supporting the driving circuit boards, as a heat sink for dissipating heat from the PDP 110 and as a ground for the electro magnetic interference (EMI) of the PDP 110.

For the purpose of the heat dissipation of the PDP 110, it is desirable for the heat spread sheet 130 to be as wide as possible on the backside thereof and for the double-sided tape to be to fix the PDP 110 to the chassis base 120 firmly without engaging the heat spread sheet 130.

In order to ease installation of the double-sided tape 140, a clearance C between the heat spread sheet 130 and the double-sided tape 140 may be increased. A large clearance, however, causes a bright image-sticking on the portion of the viewing surface of the PDP 110 corresponding to the clearance C. Bright image-sticking is the phenomenon that faint images remain despite having been over-written.

A small clearance C may eliminate the bright image-sticking, but may increase the likelihood of the double-sided tape 140 engaging the heat spread sheet 130 of the PDP 110 when the PDP 110 is attached to the chassis base 120.

Therefore, the double-sided tapes 140 should be placed at exact locations in order to minimize the clearance C between the heat spread sheet 130 and the double-sided tape 140.

A typical process for assembling the PDP 110, the chassis base 120 and the heat spread sheet 130 includes attaching the heat spread sheet 130 on the backside(opposite the viewing surface) of the PDP 110, , attaching the double-sided tapes 140 on the chassis base 120, and fixing the PDP 110 to the chassis base 120 by means of the double-sided tapes 140.

When the double-sided tapes 140 are incorrectly positioned , the clearance C between the heat spread sheet 130 and the double-sided tapes 140 is not uniform and may be locally larger than a predetermined minimum and therefore cause the aforementioned bright image sticking.

Moreover, the severely severe misalignment can cause the double-sided tapes 140 to engage the heat spread sheet 130. This can leave gaps between the heat spread sheet 130 and the chassis base 120, which is responsible for noise in the assembled unit.

US 2002/0153840 A1 discloses a structure for fixing a frame to a plasma display panel in which a plasma display apparatus comprises a plasma display panel and circuits substrates comprise drive circuits to drive the plasma display panel, a main frame to mount the circuits substrates, and adhesive tapes to fix the plasma display panel to the main frame, and small holes are provided on the portion to which the adhesive tapes of the main frame are fixed so that they are arranged regularly at established intervals.

Furthermore, JP 59020947 discloses a method for determining a display device mounting position wherein a mark for mount positioning and a positioning mark for stacking panels are provided. These marks are accurately positioned in relation to the display position.

### SUMMARY OF THE INVENTION

In one aspect of the invention, a plasma display apparatus comprises a plasma display panel; a chassis base supporting the plasma display panel; double-sided tape to fix the PDP to the chassis base; and alignment marks, formed on the chassis base, to indicate the accurate attachment positions of the double-sided tape relative to the chassis base. A heat spread sheet is placed between the chassis base and the plasma display panel , the heat spread sheet being placed between the chassis base and the plasma display panel, the heat spread sheet being divided into a plurality of pieces being spaced apart from one another by a predetermined gap, and wherein the double-sided tapes are positioned between and outside the heat spread sheets. Preferably the alignment marks are formed on a side of the chassis base proximal to the plasma display panel. Preferably the alignment marks are formed at positions between adjacent heat spread sheets. Preferably the alignment marks are formed at positions corresponding to at least a portion of the double-sided tape. Preferably the alignment marks are formed by embossing. Preferably the alignment marks are formed by recessing the surface of the chassis base corresponding to the intended position of the double sided tape. Preferably the alignment marks are formed by printing ink or fluorescent material. Preferably the alignment marks are formed along the perimeter of the surface corresponding to the intended position of the double-sided tape. Preferably the alignment marks are formed partially along the perimeter of the surface corresponding to the intended position of the double-sided tape. Preferably the alignment marks are formed in a pair along two lengthwise edges of the surface corresponding to the intended position of the double-sided tape. Preferably the alignment marks are formed in a pair along two widthwise edges of the surface corresponding to the intended position of the double-sided tape. Preferably the alignment marks are formed in a pair at diagonal positions relative to the surface corresponding to the intended position of the double-sided tape. Preferably the alignment marks are formed in a pair at diagonal corners. Preferably the alignment mark is formed into a partial bracket shape corresponding to a corner of the double-sided tape. Preferably the alignment mark is formed as a hole in the chassis base. Preferably the hole has a circular or a polygonal cross-section.

In a further aspect of the invention, a plasma display apparatus comprises a plasma display panel; a chassis base supporting the plasma display panel; one or more heat spread sheets placed between the plasma display panel and the chassis base; and alignment marks, formed on the chassis base, to indicate the accurate attachment positions of the heat spread sheets relative to the chassis base. Preferably the alignment marks are formed at positions corresponding to at least a portion of the heat spread sheets. Preferably the alignment marks are formed by embossing. Preferably the alignment marks are formed by recessing the surface of the chassis base corresponding to the intended position of the heat spread sheets. Preferably the alignment marks are formed by printing ink or fluorescent material. Preferably the alignment marks are formed along the perimeter of the surface corresponding to the intended position of the heat spread sheet. Preferably the alignment marks are formed partially along the perimeter of the surface corresponding to the intended position of the heat spread sheet. Preferably the alignment marks are formed in a pair along two lengthwise edges of the surface corresponding to the intended position of the heat spread sheet. Preferably the alignment marks are formed in a pair along two widthwise edges of the surface corresponding to the intended position of the heat spread sheet. Preferably the alignment marks are formed in a pair at diagonal positions relative to the surface corresponding to the intended position of the heat spread sheet. Preferably the alignment marks are formed in a pair at diagonal corners. Preferably the alignment mark is formed into a partial bracket shape corresponding to a corner of the heat spread sheet. Preferably the alignment mark is formed as a hole in the chassis base. Preferably the hole has a circular or a polygonal cross-section.

### BRIEF DESCRIPTION OF THE DRAWINGS

Fig. 1 is a perspective view of a disassembled plasma display apparatus according to a first embodiment.

Fig. 2 is a plan view of a chassis base of the plasma display apparatus according to the first embodiment.

Fig. 3 is a side cross-section taken on the section line III-III of Fig. 2.

Fig. 4 is a side cross-section of a chassis base of a plasma display apparatus according to a second embodiment.

Fig. 5 is a plan view of a chassis base of a plasma display apparatus according to a third embodiment.

Fig. 6 is a plan view of a chassis base of a plasma display apparatus according to a fourth embodiment.

Fig. 7 is a side cross-section taken on the section line VII-VII of Fig. 6.

Fig. 8 is a perspective view of a disassembled plasma display apparatus according to a fifth embodiment.

Fig. 9 is a plan view of a chassis base shown in Fig. 8.

Fig. 10 is a plan view of a chassis base of a plasma display apparatus according to a sixth embodiment.

Fig. 11 is a plan view of a chassis base of a plasma display apparatus according to a seventh embodiment.

Fig. 12 is a plan view of a chassis base of a plasma display apparatus according to an eighth embodiment.

Fig. 13 is a plan view of a chassis base of a plasma display apparatus according to a ninth embodiment.

Fig. 14 is a plan view of a chassis base of a plasma display apparatus according to a tenth embodiment.

Fig. 15 is a plan view of a chassis base of a plasma display apparatus according to an eleventh embodiment.

Fig. 16 is a plan view of a chassis base of a plasma display apparatus according to a twelfth embodiment.

Fig. 17 is a perspective view of a prior plasma display apparatus showing assembling a unit module.

Fig. 18 is a plan view of a chassis base of a prior plasma display apparatus.

### DETAILED DESCRIPTION OF CERTAIN INVENTIVE EMBODIMENTS

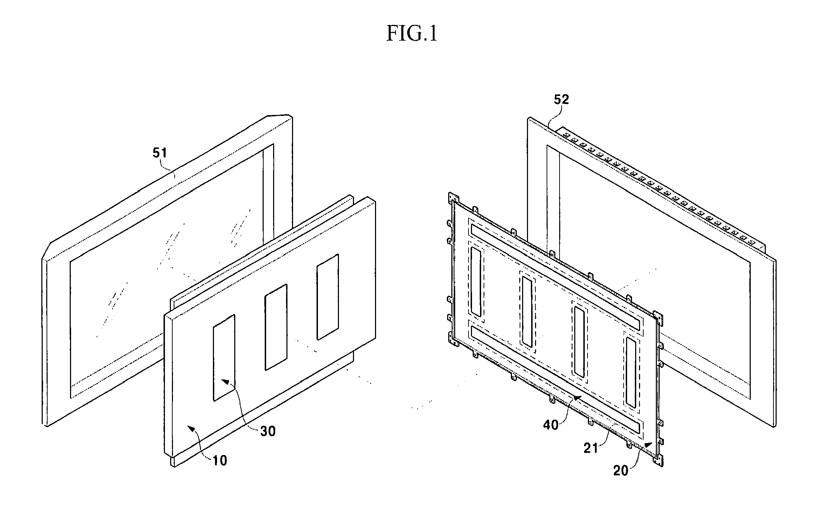

As shown in Fig. 1, a plasma display apparatus comprises a plasma display panel (PDP) 10 which produces an image by plasma discharge; a chassis base 20 positioned on a backside of the PDP 10, the backside being opposite to the viewing surface, and supporting the PDP 10; heat spread sheets 30 placed between the PDP 10 and the chassis base 20; double-sided tapes 40, maintaining a predetermined clearance from the heat spread sheet 30, and being attached on the chassis base 20 to fix the PDP 10 to the chassis base 20; a front cover 51 placed over the front of the PDP 10; and a rear cover placed over the back of the chassis base 20.

The PDP 10 is a display device using gas discharge, and the present invention relates to a configuration of the PDP 10 and other components and a method of manufacturing the same. Therefore, the detailed explanation of the PDP 10 itself is omitted, and the PDP 10 of the present invention may have various compositions and forms.

The heat spread sheet 30 serves to uniformly dissipate the heat generated from the PDP 10to eliminate the bright image sticking of the PDP 10. The heat spread sheet 30 may be made of a material such as acrylic, graphite or carbon-nano tube material, or other such material known in the art.

A single large piece of the heat spread sheet 30 may be attached on the backside of the PDP 10 for uniform heat dissipation. Alternatively, a plurality of pieces may be similarly attached. For example, 3 pieces may be used.

When the PDP 10 has a plurality of pieces of the heat spread sheets 30 attached thereto, double-sided tapes 40 may be placed between each piece of the heat spread sheets 30.

The heat spread sheet 30 is placed between the PDP 10 and the chassis base 20 joined to the PDP 10 and pressed to be in a firm contact with the backside of the PDP 10 by the bonding force of the double-sided tape 40. Therefore, it is preferable for the double-sided tape 40 to have a sufficient bonding force to maintain the firm attachment of the chassis base 20 to the PDP 10. The double-sided tapes 40 are placed between the plurality of heat spread sheets 30 and bond at multiple locations to the backside of the PDP 10 and the chassis base 20.

The double-sided tapes 40 in this case increase the bonding strength between the PDP 10 and the chassis base 20. However, they also may cause non-uniform heat dissipation in the backside of the PDP 10 due to the decrease in area covered with the heat spread sheet 30. Therefore, it is preferable to use a proper number of the heat spread sheet 30 so as not to cause the non-uniform heat dissipation.

Accordingly, the heat spread sheet 30 is divided into plural pieces, and each piece is positioned on the backside of the PDP 10 at predetermined locations. The double-sided tapes 40 may be placed between and outside the pieces of the heat spread sheet 30 to form a band of pieces of the double-sided tape 40 around the heat spread sheets 30 to attach the chassis base 20 to the backside of the PDP 10.

Driving circuit boards (not shown) for driving the PDP 10 are attached on a backside of the chassis base 20, the backside being opposite to the side where the PDP 10 is attached.

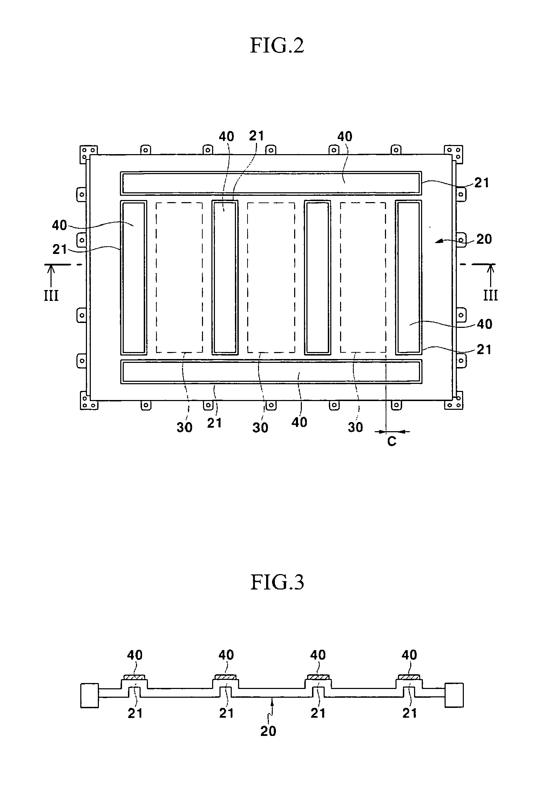

On the chassis base 20, as shown in Fig. 2 and Fig. 3, are formed alignment marks 21 to guide the placement of the double-sided tapes 40. The alignment marks 21 ensure that the tapes are attached at correct positions on the chassis base 20. The marks are positioned such that the double-sided tapes 40 maintain a predetermined clearance C from the heat spread sheet 30. During the assembling process, the embossed alignment marks 21 guide a worker (or a working machine in an automated line) to place the double-sided tapes 40 and the heat spread sheet 30 at more accurate positions.

The alignment mark 21 may be formed by embossing the entire surface where the double-sided tape is to be attached.

Correctly positioned double-sided tapes 40 provide consistent and uniform clearance C from the heat spread sheet 30. With better control, the Clearance C may be reduced enough to effectively eliminate the bright image-sticking.

Since the alignment marks 21 guide the correct placement of the double-sided tapes 40. The heat spread sheet 30 will not engage the tapes. Local gaps between the PDP 110 and the chassis base 120, will be avoided and noise from such gaps eliminated.

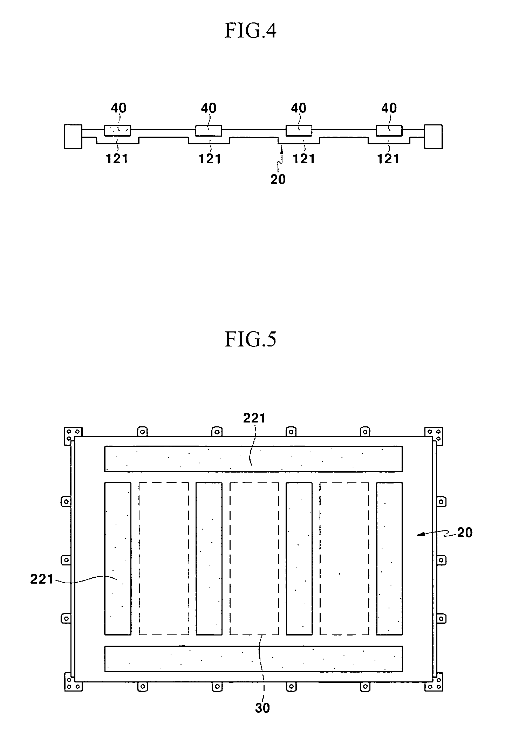

Fig. 4 is a side cross-section of a chassis base of a plasma display apparatus according to a second embodiment of the present invention. According to Fig. 4, the alignment mark 121 of the present embodiment is formed by recessing the entire attachment surface where the double-sided tape 40 is attached.

The recessed alignment mark 121 is preferable for manufacturing the chassis base 20 by a press. Alternatively, both recessed and embossed alignment marks 121 are possible. The chassis base 20 may be manufactured by use of a die-casting.

Fig. 5 is a plan view of a chassis base of a plasma display apparatus according to a third embodiment of the present invention. The alignment mark 221 of the present embodiment, as shown in Fig. 5, is highlighted by printing a mark such as an ink mark or a fluorescent mark on the attachment surface for the double-sided tape 40. This guides a worker (or a working machine) to recognize the attachment surface easily and attach the double-sided tape 40 correctly.

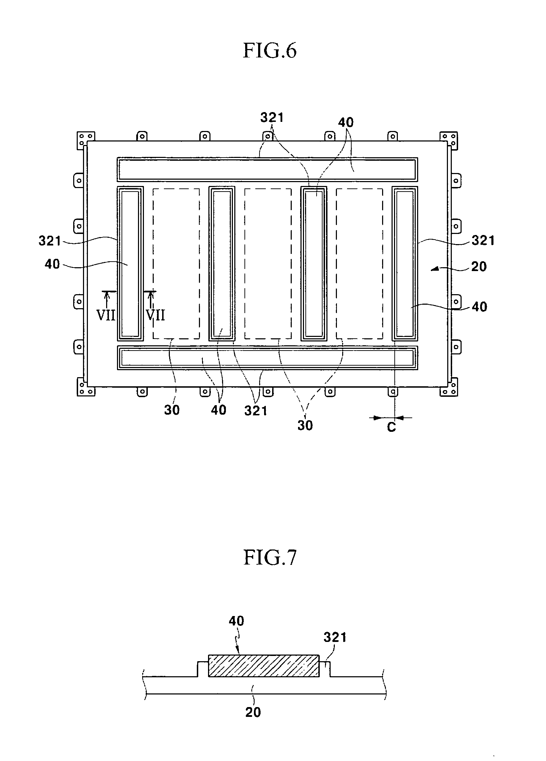

Fig. 6 is a plan view of a chassis base of a plasma display apparatus according to a fourth embodiment of the present invention. And Fig. 7 is a side cross-section taken on the section line VII-VII of Fig. 6. As shown in these figures, the alignment mark 321 by embossing or recessing lines only along the perimeter of the attachment surface of the double-sided tape 40.

The alignment mark 321, as shown in Fig. 7, may be formed by embossing a partial area of the attachment surface for the double-sided tape 40 on the chassis base 20, i.e., a line along the perimeter of the attachment surface for the double-sided tape 40. Therefore, the double-sided tape 40 is guided to be set inside the alignment mark 321. The alignment mark 321 may be printed in ink or fluorescent material or other materials along the perimeter of the attachment surface for the double-sided tape 40.

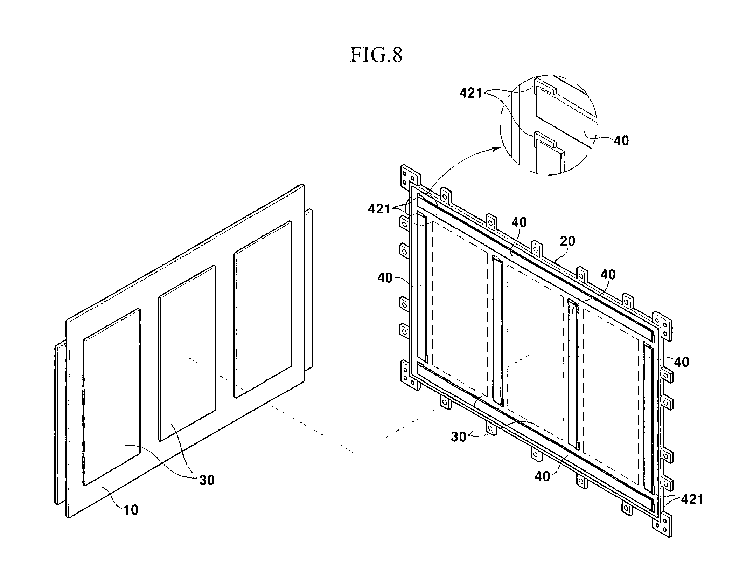

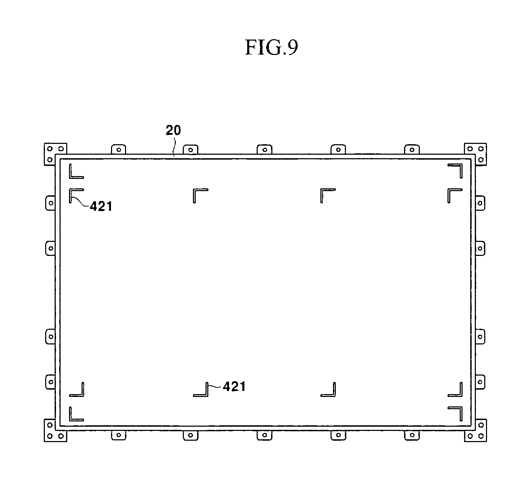

Fig. 8 is a perspective view of a disassembled plasma display apparatus according to a fifth embodiment of the present invention. And Fig. 9 is a plan view of a chassis base shown in Fig. 8. As shown in these figures, the alignment mark 421 is formed at least partly along the perimeter of the attachment surface for the double-sided tape 40. In order to minimize the alignment mark area needed for guiding the double-sided tape 40, the alignment marks 421 are located at two diagonal corners of the rectangular attachment surface for the double-sided tape 40, and are formed in a partial bracket shape "┌", "┘". Other shapes such as, but not limited to, broken lines, or dots or pairs or multiple instances of these shapes.

For example, the alignment marks may be formed in a pair along two lengthwise edges or two widthwise edges of the double-sided tape 40.

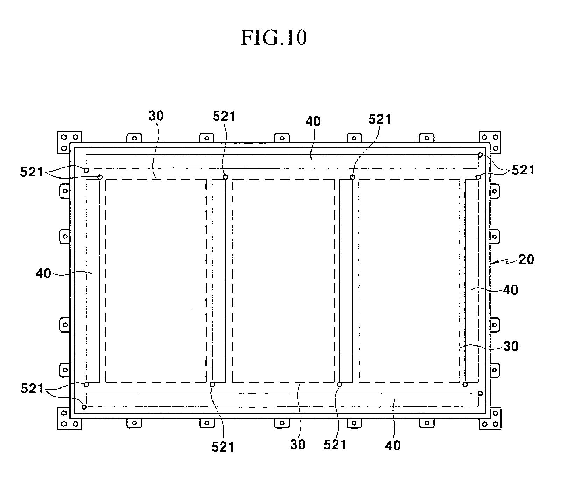

Fig. 10 is a plan view of a chassis base of a plasma display apparatus according to a sixth embodiment of the present invention. According to Fig. 10, the alignment mark 521 of the present embodiment is a circular hole. Such a hole may be made by punching the chassis base 20. The chassis base 20 may be made of a metallic material so that punching is convenient. In order to minimize the punching process the alignment marks 521 may be located at two diagonal corners of the rectangular attachment surface for the double-sided tape 40.

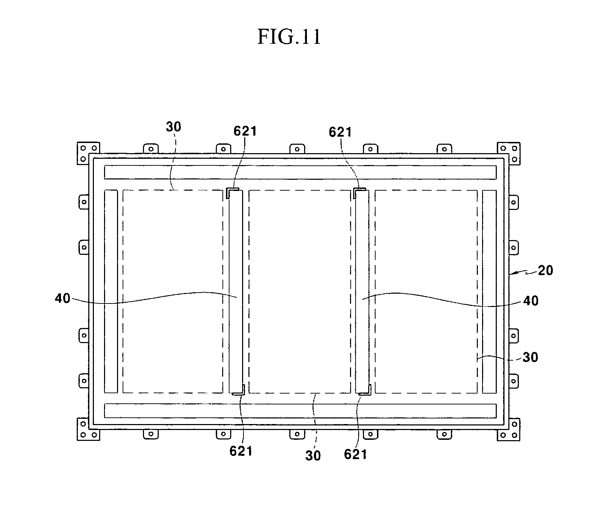

Fig. 11 is a plan view of a chassis base of a plasma display apparatus according to a seventh embodiment of the present invention. According to Fig. 11, the alignment marks 621 of the present embodiment may be formed at positions corresponding to all or to a portion of the double-sided tapes 40 on the chassis. For example, the alignment marks 621 may be formed between the heat spread sheets 30 and not outside the heat spread sheets 30. Alternatively the marks may be formed outside the heat spread sheets 30 and not inside the heat spread sheets 30.Using this arrangement, the number of the alignment marks 621 may be minimized.

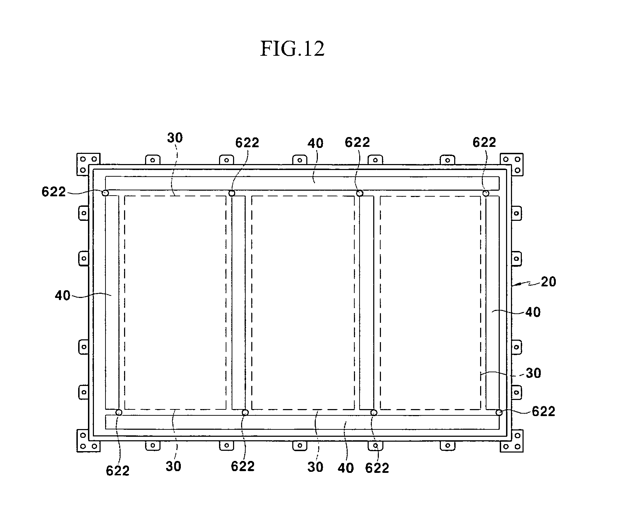

Fig. 12 is a plan view of a chassis base of a plasma display apparatus according to a eighth embodiment of the present invention. According to Fig. 12, the alignment marks 622 of the present embodiment are formed for some, but not all of the double-sided tapes 40 on the chassis base 20. In this example, the alignment marks 622 are positioned to guide only vertical double-sided tapes 40. In this example, the punched circular alignment marks 622 are located at two diagonal corners of the rectangular attachment surface for the double-sided tape 40 to minimize the alignment mark area. Other embodiments may use other locations such as on an edge.

In other embodiments, the alignment marks 622 may be shared with one or more other double-sided tapes 40. For example, a single alignment mark 622 is used to guide both the horizontal and vertical double-sided tapes 40.

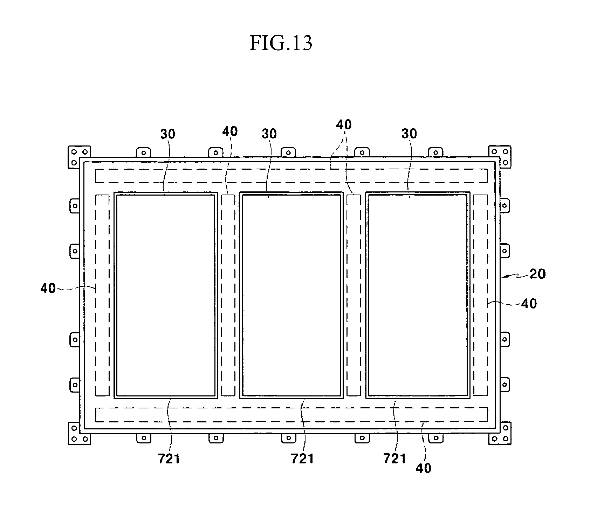

Fig. 13 is a plan view of a chassis base of a plasma display apparatus according to a ninth embodiment of the present invention. According to Fig. 13, the alignment marks 721 of the present embodiment are formed on the chassis base 20 to guide not only the double-sided tapes 40 to be correctly positioned but also to guide the correct positioning of the heat spread sheets 30. Some marks 721 may be for the heat spread sheets 30 and/or some may be for both the double sided tapes 40 and the heat spread sheets 30.

The alignment marks 721 may be formed by embossing or recessing the entire attachment surface on the chassis base 20 corresponding to the heat spread sheet 30, or by printing with ink or a fluorescent material. Other suitable methods may also be used.

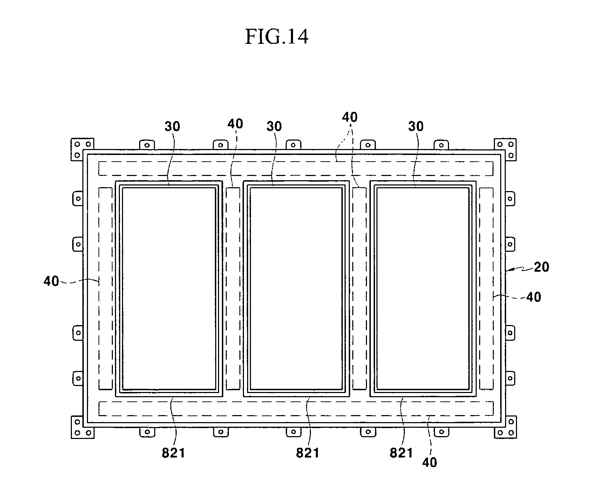

Fig. 14 is a plan view of a chassis base of a plasma display apparatus according to a tenth embodiment of the present invention. As shown in Fig. 14, the alignment mark 821 may be formed along the perimeter of the attachment surface on the chassis base 20 for the heat spread sheet 30.

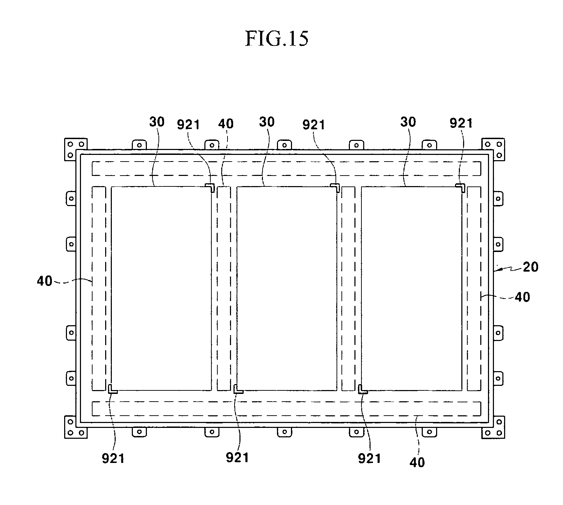

Fig. 15 is a plan view of a chassis base of a plasma display apparatus according to an eleventh embodiment of the present invention. According to Fig. 15, the alignment marks 921 of the present embodiment may be formed along a portion of the perimeter of the areas in the attachment surface for the heat spread sheet 30. The alignment marks 921 may be located at two diagonal corners of the rectangular attachment surface on the chassis base 20 for the heat spread sheet 30. This may be done to minimize the number of alignment marks needed for guiding the heat spread sheet 30.

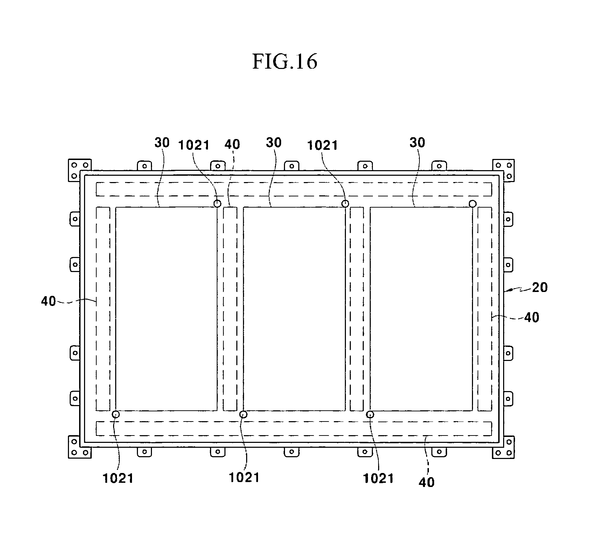

Fig. 16 is a plan view of a chassis base of a plasma display apparatus according to a twelfth embodiment of the present invention.

According to Fig. 16, the alignment mark 1021 of the present embodiment is a set of punched holes at positions near the edges of the attachment surface on the chassis base 20 corresponding to the heat spread sheet 30. In some embodiments the alignment marks 1021 are located at two diagonal corners of the rectangular attachment surface on the chassis base 20

The alignment marks used in all of the embodiments explained above may be used for guiding the double-sided tape 40 or for guiding the heat spread sheet 30 to the correct attachment position.

Although exemplary embodiments of the present invention have been described in detail hereinabove, it should be understood that many variations and/or modifications of the basic inventive concept taught therein will fall within the scope of the present invention, as defined in the claims.

The plasma display apparatus of the present invention provides an effective way for arranging and attaching the double-sided tapes and the heat spread sheets placed between the plasma display panel and the chassis base.

Also, by monitoring the double-sided tapes and the attachment positions corresponding to the heat spread sheets during the assembling process, the attachment process of double-sided tapes is easily carried out, and clearances between the heat spread sheets and the double-sided tapes are minimized.

Since the alignment marks facilitate the correct attachment of the double-sided tape and the heat spread sheet with a uniform clearance, the present invention substantially prevents effectively the bright image-sticking due to non-uniform clearance between the double-sided tape and the heat spread sheet and noise from the unit module due to the misaligned attachment of the double-sided tape and the heat spread sheet.

While the above description has pointed out novel features of the invention as applied to various embodiments, the skilled person will understand that various omissions, substitutions, and changes in the form and details of the device or process illustrated may be made without departing from the scope of the invention.

## Claims

1. A plasma display apparatus comprising:
a plasma display panel (10);
a chassis base (20) supporting the plasma display panel (10),
**characterized in that**
the plasma display apparatus further comprises at least one double-sided tape (40) to fix the plasma display panel (10) to the chassis base (20), and alignment marks (21, 121, 221, 321, 421, 521, 621, 622, 721, 821, 921, 1021), the alignment marks (21, 121, 221, 321, 421, 521, 621, 622, 721, 821, 921, 1021) being formed on the chassis base (20), to indicate the accurate attachment position of the at least one double-sided tape (40) relative to the chassis base and/or
the plasma display apparatus further comprises at least one heat spread sheets (30) placed between the plasma display panel (10) and the chassis base (20), and alignment marks (21, 121, 221, 321, 421, 521, 621, 622, 721, 821, 921, 1021), the alignment marks (21, 121, 221, 321, 421, 521, 621, 622, 721, 821, 921, 1021) being formed on the chassis base (20), to indicate the accurate attachment position of the at least one heat spread sheet (30) relative to the chassis base.

2. The plasma display apparatus of claim 1. wherein a heat spread sheet (30) is placed between the chassis base (20) and the plasma display panel (10), the heat spread sheet (30) being divided into a plurality of pieces being spaced apart from one another by a predetermined gap, and wherein the at least one double-sidedtape (40) is positioned between and/or outside the heat spread sheets (30).

3. The plasma display apparatus of claim 2, wherein the alignment marks marks (21, 121, 221, 321, 421, 521, 621, 622, 721, 821, 921, 1021) are formed on a side of the chassis base (20) proximal to the plasma display panel (10).

4. The plasma display apparatus of claim 3, wherein the alignment marks (21, 121, 221, 321, 521, 621, 622, 921, 1021) are formed at positions between adjacent heat spread sheets (30).

5. The plasma display apparatus of claim 1, wherein the alignment marks (21, 121, 221, 321, 421, 521, 621, 622) are formed at positions corresponding to at least a portion of the double-sided tape (40).

6. The plasma display apparatus of claim 1, wherein the alignment marks (21, 121, 221, 321, 421, 521, 621, 622, 721, 821, 921, 1021) are formed by printing ink or fluorescent material and/or the alignment marks (21, 121, 221, 321, 721, 821, 921, 1021) are formed at least partially along the perimeter of a surface corresponding to the intended position of the double-sided tape (40) or heat spread sheet (30).

7. The plasma display apparatus of claim 6, wherein, as a first alternative, the alignment marks (421, 521, 621, 622) are formed in a pair along two lengthwise edges of a surface corresponding to the intended position of the double-sided tape (40) or heat spread sheet (30) or, as a second alternative,
the alignment marks (421, 521, 621, 622) are formed in a pair at diagonal positions relative to a surface corresponding to the intended position of the double-sided tape (40) or heat spread sheet (30).

8. The plasma display apparatus of claim 7, wherein, in the second alternative, the alignment marks (421, 521, 621, 622) are formed in a pair at diagonal corners.

9. The plasma display apparatus of claim 8, wherein the alignment marks (421, 621) are formed into a partial bracket shape (921) corresponding to a corner of the double-sided tape (40) or the heat spread sheet (30) or the alignment marks (521, 622) are formed as a hole in the chassis base (20).

10. The plasma display apparatus of claim 9, wherein the hole has a circular or a polygonal cross-section.

11. The plasma display apparatus of claim 1, wherein the alignment marks (721, 821, 921, 1021) are formed at positions corresponding to at least a portion of the heat spread sheets (30).

## Patentansprüche

1. Plasmaanzeigetafel, aufweisend:
ein Plasmaanzeigepaneel (10);
eine Chassisgrundplatte (20), die das Plasmaanzeigepaneel (10) trägt,
**dadurch gekennzeichnet, dass**
die Plasmaanzeigetafel weiterhin zumindest ein doppelseitiges Klebeband (40) zur Befestigung des Plasmaanzeigepaneels (10) an der Chassisgrundplatte (20) sowie Ausrichtungsmarkierungen (21, 121, 221, 321, 421, 521, 621, 622, 721, 821, 921, 1021) aufweist, wobei die Ausrichtungsmarkierungen (21, 121, 221, 321, 421, 521, 621, 622, 721, 821, 921, 1021) auf der Chassisgrundplatte (20) ausgebildet sind, um die genaue Befestigungsposition des zumindest einen doppelseitigen Klebebandes (40) bezüglich der Chassisgrundplatte anzuzeigen,
und/oder wobei
die Plasmaanzeigetafel weiterhin zumindest eine Platte (30) zur Wärmeverteilung, die zwischen dem Plasmaanzeigepaneel (10) und der Chassisgrundplatte (20) angeordnet ist, sowie Ausrichtungsmarkierungen (21, 121, 221, 321, 421, 521, 621, 622, 721, 821, 921, 1021) aufweist, wobei die Ausrichtungsmarkierungen (21, 121, 221, 321, 421, 521, 621, 622, 721, 821, 921, 1021) auf der Chassisgrundplatte (20) ausgebildet sind, um die genaue Befestigungsposition der zumindest einen Platte (30) zur Wärmeverteilung bezüglich der Chassisgrundplatte anzuzeigen.

2. Plasmaanzeigelafel nach Anspruch 1, wobei eine Platte (30) zur Wärmeverteilung zwischen der Chassisgrundplatte (20) und dem Plasmaanzeigepaneel (10) angeordnet ist, und wobei die Platte (30) zur Wärmeverteilung in eine Vielzahl von Teilen unterteilt ist, die in einem vorbestimmten Abstand zueinander beabstandet sind, und wobei das zumindest eine doppelseitige Klebeband (40) zwischen und/oder außerhalb der Platte (30) zur Wärmeverteilung positioniert ist.

3. Plasmaanzeigetafel nach Anspruch 2, wobei die Ausrichtungsmarkierungen (21, 121, 221, 321, 421, 521, 621, 622, 721, 821, 921, 1021) auf einer proximal zum Plasmaanzeigepaneel (10) gelegenen Seite der Chassisgrundplatte (20) ausgebildet sind.

4. Plasmaanzeigetafel nach Anspruch 3, wobei die Ausrichtungsmarkierungen (21, 121, 221, 321, 521, 621, 622, 921, 1021) in Positionen zwischen zueinander benachbarten Platten (30) zur Wärmeverteilung ausgebildet sind.

5. Plasmaanzeigetafel nach Anspruch 1, wobei die Ausrichtungsmarkierungen (21, 121, 221, 321, 421, 521, 621, 622) in Positionen ausgebildet sind, die zumindest einem Bereich des doppelseitigen Klebebandes (40) entsprechen.

6. Plasmaanzeigetafel nach Anspruch 1, wobei die Ausrichtungsmarkierungen (21, 121, 221, 321, 421, 521, 621, 622, 721, 821, 921, 1021) durch Druckfarbe oder fluoreszierendes Material ausgebildet sind, und/oder wobei die Ausrichtungsmarkierungen (21, 121, 221, 321, 721, 821, 921, 1021) zumindest teilweise entlang des Umfangs einer Oberfläche ausgebildet sind, die der vorgesehenen Position des doppelseitigen Klebebandes (40) oder der Platte (30) zur Wärmeverteilung entspricht.

7. Plasmaanzeigetafel nach Anspruch 6, wobei als erste Alternative die Ausrichtungsmarkierungen (421, 521, 621, 622) als ein Paar entlang zweier Längskanten einer Oberfläche ausgebildet sind, die der vorgesehenen Position des doppelseitigen Klebebandes (40) oder der Platte (30) zur Wärmeverteilung entspricht, oder wobei als zweite Alternative
die Ausrichtungsmarkierungen (421, 521, 621, 622) als ein Paar in bezüglich einer Oberfläche, die der vorgesehenen Position des doppelseitigen Klebebandes (40) oder der Platte (30) zur Wärmeverteilung entspricht, diagonal gegenüberliegenden Positionen ausgebildet sind.

8. Plasmaanzeigetafel nach Anspruch 7, wobei gemäß der zweiten Alternative die Ausrichtungsmarkierungen (421, 521, 621, 622) als ein Paar in diagonal gegenüberliegenden Ecken ausgebildet sind.

9. Plasmaanzeigetafel nach Anspruch 8, wobei die Ausrichtungsmarkierungen (421, 621) in einer partiellen Klammerform (921) ausgebildet sind, die einer Ecke des doppelseitigen Klebebandes (40) oder der Platte (30) zur Wärmeverteilung entspricht, oder wobei die Ausrichtimgsmarkierungen (521, 622) als Loch in der Chassisgrundplatte (20) ausgebildet sind.

10. Plasmaanzeigetafel nach Anspruch 9, wobei das Loch einen kreisförmigen oder polygonalen Querschnitt aufweist.

11. Plasmaanzeigetafel nach Anspruch 1, wobei die Ausrichtungsmarkierungen (721, 821, 921, 1021) in Positionen ausgebildet sind, die zumindest einem Bereich der Platte (30) zur Wärmeverteilung entsprechen.

## Revendications

1. Appareil d'affichage à plasma comportant :
un panneau d'affichage à plasma (10) ;
une base (20) de châssis supportant le panneau d'affichage à plasma (10),
**caractérisé en ce que**
l'appareil d'affichage à plasma comporte en outre au moins un ruban double-face (40) pour fixer le panneau (10) d'affichage à plasma à la base de châssis (20), et des repères d'alignement (21, 121, 221, 321, 421, 521, 621, 622, 721, 821, 921, 1021), les repères d'alignement (21, 121, 221, 321, 421, 521, 621, 622, 721, 821, 921, 1021) étant formés sur la base de châssis (20) pour indiquer la position de fixation précise du, au moins un, ruban double-face (40) par rapport à la base du châssis et/ou
l'appareil d'affichage à plasma comporte en outre au moins une feuille (30) d'étalement de chaleur placée entre le panneau (10) d'affichage à plasma et la base de châssis (20), et des repères d'alignement (21, 121, 221, 321, 421, 521, 621, 622, 721, 821, 921, 1021), les repères d'alignement (21, 121, 221, 321, 421, 521, 621, 622, 721, 821, 921, 1021) étant formés sur la base de châssis (20), pour indiquer la position de fixation précise de la, au moins une, feuille d'étalement de chaleur (30) par rapport à la base du châssis.

2. Appareil d'affichage à plasma selon la revendication 1, dans lequel une feuille d'étalement de chaleur (30) est placée entre la base de châssis (20) et le panneau d'affichage à plasma (10), la feuille d'étalement de chaleur (30) étant divisée en de multiples pièces espacées les unes des autres d'un intervalle prédéterminé, et dans lequel le, au moins un, ruban double-face (40) est positionné entre les feuilles d'étalement de chaleur (30) et/ou à l'extérieur de celles-ci.

3. Appareil d'affichage à plasma selon la revendication 2, dans lequel les repères d'alignement (21, 121, 221, 321, 421, 521, 621, 622, 721, 821, 921, 1021) sont formés sur un côté de la base de châssis (20) proximal par rapport au panneau d'affichage à plasma (10).

4. Appareil d'affichage à plasma selon la revendication 3, dans lequel les repères d'alignement (21, 121, 221, 321, 521, 621, 622, 921, 1021) sont formés dans des positions situées entre des feuilles d'étalement de chaleur adjacentes (30).

5. Appareil d'affichage à plasma selon la revendication 1, dans lequel les repères d'alignement (21, 121, 221, 321, 421, 521, 621, 622) sont formés en des positions correspondant à au moins une partie du ruban double-face (40).

6. Appareil d'affichage à plasma selon la revendication 1, dans lequel les repères d'alignement (21, 121, 221, 321, 421, 521, 621, 622, 721, 821, 921, 1021) sont formés par l'impression d'une encre ou d'une matière fluorescente et/ou les repères d'alignement (21, 121, 221, 321, 721, 821, 921, 1021) sont formés au moins partiellement le long du périmètre d'une surface correspondant à la position prévue du ruban double-face (40) ou de la feuille d'étalement de chaleur (30).

7. Appareil d'affichage à plasma selon la revendication 6, dans lequel, en tant que première variante, les repères d'alignement (421, 521, 621, 622) sont formés en une paire le long de deux bords longitudinaux d'une surface correspondant à la position prévue du ruban double-face (40) ou de la feuille d'étalement de chaleur (30) ou bien, en tant que seconde variante,
les repères d'alignement (421, 521, 621, 622) sont formés dans une paire de positions diagonales par rapport à une surface correspondant à la position prévue du ruban double-face (40) ou de la feuille d'étalement de chaleur (30).

8. Appareil d'affichage à plasma selon la revendication 7, dans lequel, dans la seconde variante, les repères d'alignement (421, 521, 621, 622) sont formés dans une paire d'angles diagonaux.

9. Appareil d'affichage à plasma selon la revendication 8, dans lequel les repères d'alignement (421, 621) sont formés en une forme de crochet partiel (921) correspondant à un angle du ruban double-face (40) ou de la feuille d'étalement de chaleur (30), ou bien les repères d'alignement (521, 622) sont réalisés sous la forme d'un trou dans la base (20) du châssis.

10. Appareil d'affichage à plasma selon la revendication 9, dans lequel le trou a une section transversale circulaire ou polygonale.

11. Appareil d'affichage à plasma selon la revendication 1, dans lequel les repères d'alignement (721, 821, 921, 1021) sont formés dans des positions correspondant à au moins une partie des feuilles d'étalement de chaleur (30).
